# DEMANDE DE BREVET EUROPEEN

(11) **EP 2 199 425 A1**
(43) Date de publication de la demande: **23.06.2010**
(21) Numéro de dépôt: 08172179.7
(22) Date de dépôt: 18.12.2008
(51) Int. Cl.: C23C 14/24, C23C 14/56, C23C 14/16

(54) **Générateur de vapeur industriel pour le dépôt d'un revêtement d'alliage sur une bande métallique (II)**

(71) Demandeur: ArcelorMittal France, 93212 La Plaine St Denis Cedex (FR)
(72) Inventeur: Silberberg, Eric, 5340 Gesves (BE); Vanhee, Luc, 08600 Frommelennes (FR); Monnoyer, Maxime, 4550 Nandrin (BE); Schmitz, Bruno, 4000 Liège (BE)
(74) Mandataire: pronovem

(57) **Abrégé**

La présente invention se rapporte à un procédé pour déposer un revêtement d'alliage métallique sur une bande métallique, au moyen d'un générateur de vapeur comprenant une chambre à vide (6) englobant une tête de dépôt de vapeur, appelée éjecteur (3), configurée pour créer un jet de vapeur d'alliage métallique à la vitesse sonique et en communication avec un dispositif mélangeur (14), lui-même relié en amont respectivement à au moins deux creusets (11, 12) contenant des métaux différents, sous forme liquide, et reliés par une conduite propre (4, 4') au mélangeur (14), **caractérisé en ce que :**
- on régule la vitesse d'écoulement de chacune des vapeurs métalliques à l'entrée du mélangeur (14) de manière à ce que ladite vitesse d'écoulement desdites vapeurs à l'entrée du mélangeur soit inférieure d'un facteur 10, de préférence d'un facteur 50, à la vitesse sonique ;
- on ajuste indépendamment la concentration de chaque métal lors du mélange des vapeurs à déposer sur le substrat (7).

## Description

### Objet de l'invention

La présente invention se rapporte à un générateur de vapeur industriel pour revêtir sous vide et en continu un substrat en mouvement, plus particulièrement une bande métallique, au moyen de vapeurs métalliques en vue de former une couche d'alliage métallique sur sa surface, de manière à lui assurer une excellente résistance à la corrosion tout en conservant de bonnes caractéristiques d'emboutissage et de soudabilité.

### Etat de la technique

Il est connu depuis la fin des années 1980 que le dépôt de certains alliages, tels que ZnMg, à la surface d'une bande d'acier, a un rôle protecteur de l'acier. L'excellente tenue en corrosion de l'alliage ZnMg est attribuée à la nature des produits de corrosion formés à la surface de la bande selon une couche extrêmement dense jouant le rôle de film-barrière.

Un tel dépôt d'alliage n'est généralement possible au moyen des techniques habituelles telles que le dépôt électrolytique, le revêtement au trempé, etc., que dans certaines limites de composition. Ainsi, à la pression atmosphérique, on peut avoir contamination du bain de métal liquide par l'oxygène de l'air, qui forme des mattes d'oxydes à la surface du bain.

Si on souhaite obtenir des gammes d'épaisseurs et de compositions étendues, la seule issue possible est souvent l'évaporation sous vide du métal liquide, pur ou sous forme d'alliage (technique PVD, *Pressure Vapor Deposition*)*.*

Dans le cadre de cette technique, il est connu de placer le substrat dans une enceinte sous vide maintenue à basse température et contenant un creuset de métal fondu. Le dépôt s'effectue alors sur toutes les parois dont la température est inférieure à la température de la vapeur métallique. Pour augmenter le rendement de dépôt sur le substrat et éviter les gaspillages, on a donc intérêt à chauffer les parois de l'enceinte.

Dans le document WO-A-97/47782, on décrit un procédé pour revêtir en continu un substrat en mouvement dans lequel la vapeur métallique est générée en chauffant par induction un creuset contenant un bain constitué par le métal de revêtement dans une enceinte sous vide. La vapeur s'échappe du creuset par une conduite qui l'amène vers un orifice de sortie, de préférence calibré, de manière à former un jet dirigé vers la surface du substrat à revêtir. L'utilisation d'un orifice sous forme d'une fente longitudinale de section étroite permet la régulation du débit massique de vapeur, à une vitesse sonique constante le long de la fente (col sonique), ce qui procure l'avantage d'obtenir un dépôt uniforme. On se référera par la suite à cette technique en utilisant l'acronyme « JVD » (pour *Jet Vapor Deposition*)*.*

Cette technologie présente cependant plusieurs défauts, dont notamment :
- l'alimentation permanente en métal liquide implique de prévoir le retour à la cuve de celui-ci en un ou plusieurs points ;
- le métal liquide comprenant des impuretés, il y a concentration de ces impuretés en surface du bain suite à l'évaporation, ce qui réduit le débit. L'uniformité du bain est nécessaire pour obtenir un dépôt uniforme. Il s'agit de ramener du liquide frais à un endroit tout en enlevant du liquide usagé à un autre endroit. Une solution serait un écrémage de la surface ou un recyclage de la charge mais toute opération mécanique est rendue difficile sous vide ;
- la difficulté d'adapter la fente d'évaporation à une largeur de bande variable, ce qui implique des moyens d'occultation de part et d'autre de la fente, et partant la réalisation d'une étanchéité à la vapeur sous vide et à 700°C, ce qui n'est pas aisé à réaliser ;
- la difficulté d'occulter la fente lorsque le mouvement de la bande s'interrompt, ce qui impliquerait la présence d'une vanne linéaire étanche sur une longueur typique de 2 mètres ou plus ;
- la grande inertie thermique du système (au moins plusieurs minutes) ;
- le chauffage, réalisé par induction sous vide, nécessite de passer toute la puissance électrique de chauffage via des connecteurs électriques au travers de la paroi étanche au vide, ce qui ne facilite pas l'accessibilité et la maintenabilité de l'installation.

Par ailleurs, l'état de la technique n'apporte pas de solution satisfaisante à la nécessité de réaliser le co-dépôt de deux métaux distincts, impliquant le mélange de deux jets en sortie de l'évaporateur. L'utilisation de boîtes de mélange intermédiaires à chicanes n'a apporté aucun résultat suffisamment probant.

Une première façon de procéder pour déposer un revêtement d'alliage sur une bande est d'effectuer d'abord un dépôt d'une couche du premier métal, tel que du zinc, par exemple par revêtement au trempé, électrolyse ou pulvérisation magnétron sous vide, suivi du dépôt d'une couche d'un second métal, tel que l'aluminium, par exemple sous vide, et d'effectuer enfin un traitement thermique de diffusion, par exemple un recuit à basse température, qui réalise l'alliage.

L'avantage de ce procédé est d'être simple dans sa conception, permettant une régulation étape par étape.

Un premier inconvénient est cependant de multiplier les étapes du procédé et donc son coût. En particulier, le traitement thermique de diffusion consomme une quantité d'énergie non négligeable. Par exemple, si l'épaisseur relative du revêtement est de 1%, on doit apporter l'énergie requise à toute l'épaisseur du produit final, c'est-à-dire 100%, ce qui correspond à plusieurs mégawatt pour une ligne industrielle.

Ainsi, dans le document WO-A-02/14573, on décrit l'élaboration d'un revêtement à partir d'un revêtement zingué de base obtenu par un procédé conventionnel de galvanisation au trempé ou électrozingué, lui-même revêtu ensuite de magnésium sous vide. Un chauffage rapide par induction permet de remettre pendant quelques secondes le dépôt en fusion et d'obtenir après refroidissement, une répartition microstructurale favorable de phase alliée ZnMg dans toute l'épaisseur de la couche.

Dans le document FR 2 843 130 A, on décrit un procédé de revêtement d'une surface de matériau métallique, selon lequel :
- on réalise un premier revêtement dudit matériau par une couche de métal ou d'alliage métallique,
- on réalise un traitement thermique sur le premier revêtement par un moyen de chauffage rapide de manière à porter la surface dudit premier revêtement à une température inférieure à la température de fusion du matériau métallique et
- on réalise un dépôt d'un deuxième revêtement à partir d'un métal ou d'un alliage métallique.

La Demanderesse a en outre proposé un produit industriel bicouche électro-zingué/alliage ZnMg obtenu par la voie PVD (EP-A-0 756 022), ainsi qu'une amélioration du procédé avec un système de chauffage infrarouge pour réaliser l'alliation du magnésium avec le zinc afin de minimiser la formation de phase intermétallique fragile FeZn.

Un deuxième inconvénient est que tous les types d'acier n'acceptent pas ce traitement thermique. Par exemple, les aciers BH (*bake hardening*) sont des aciers malléables, déformables, anticorrosion à destination de l'automobile, qui présentent des instabilités qui sont déplacées lors de la cuisson de peinture, ce qui provoque le durcissement de la tôle. Ce produit présente donc une difficulté liée à un durcissement qui résulte de son réchauffement. Un dépôt direct d'alliage permettrait donc de remédier à ces inconvénients.

Une autre façon de procéder est donc de réaliser des alliages de métal de revêtement par dépôt direct de l'alliage sans traitement thermique, en contrôlant rigoureusement la concentration des deux métaux dans le creuset. Par exemple, si on met 50% Zn et 50% Mg dans le creuset, on obtient un alliage 85% Zn / 15% Mg, vu les vitesses d'évaporation différentes. Toutefois ce contrôle implique de grandes difficultés de gestion du système, vu la variation continuelle de concentrations dans le creuset. En particulier, il est difficile d'assurer l'homogénéité dans le creuset, surtout si celui-ci n'est pas de section circulaire. Par exemple, POSCO (publication : « Next Generation Automotive Steels at POSCO », Janv. 2008), propose un revêtement obtenu par PVD à très haute vitesse, à haut rendement de vapeur et haut rendement énergétique, notamment sous forme de codépôt d'alliage à partir d'une seule source d'évaporation.

Encore une autre façon de procéder selon l'état de la technique consiste à utiliser deux creusets générant chacun un type de vapeur, les deux vapeurs générées étant dirigées par une canalisation vers un dispositif mélangeur, à partir duquel l'alliage est déposé sur la bande.

Le brevet BE 1010720 A3 décrit un procédé pour revêtir en continu un substrat en mouvement au moyen d'un alliage métallique en phase vapeur, dans lequel on procède à l'évaporation des différents constituants de l'alliage dans des éléments distincts appropriés et dont on canalise les différentes vapeurs métalliques obtenues vers l'endroit où est opéré le dépôt. Une des vapeurs issues des bains métalliques contenant les composants de l'alliage métallique joue le rôle d'élément propulseur vis-à-vis des autres vapeurs métalliques présentes.

Dans le document WO-A-02/06558, un revêtement ZnMg est obtenu sous vide par évaporation à partir de deux creusets, l'un contenant le zinc et l'autre le magnésium. Avant projection sur la bande, les vapeurs sont mélangées dans un dispositif d'étranglement sous forme de plaques munies de trous ou fentes, qui permet d'obtenir une vitesse sonique et un débit de vapeur maximum. Cependant, la haute vitesse des vapeurs avant le mélange rend très difficile l'obtention d'un mélange homogène par diffusion moléculaire.

Dans L. Baptiste et al., "Electromagnetic lévitation : A new technology for high rate physical vapour deposition of coatings onto metallic strip", Surface & Coatings Technology 202 (2007) 1189-1193, on propose un procédé basé sur la technologie de lévitation des matériaux conducteurs dans des champs électromagnétiques de haute fréquence. Par un dessin approprié des bobines d'induction, on peut obtenir des densités de puissance élevées et on peut facilement évaporer des métaux à faibles pressions de vapeur tels que l'aluminium, le nickel ou le cuivre, de même que leurs alliages. La vapeur produite est guidée vers le substrat par un système de distribution de vapeur spécialement conçu, qui permet d'obtenir une bonne uniformité de revêtement et une très grande utilisation de vapeur.

Le document US-A-5,002,837 décrit le dépôt par évaporation d'un revêtement bicouche Zn/ZnMg avec une phase totalement alliée Zn₂Mg ou 2n₂Mg/2n₁₁Mg₂.

### Buts de l'invention

La présente invention vise à fournir une solution qui permette de s'affranchir des inconvénients de l'état de la technique.

En particulier, l'invention vise à atteindre notamment les objectifs suivantes :
- pas de source liquide dans l'enceinte sous vide pour le dépôt ;
- simplicité de réalisation ;
- réduction très significative de la longueur de mélange de deux ou plusieurs vapeurs métalliques ;
- possibilité de régulation différenciée et ajustable très rapidement des teneurs en métaux d'alliage individuels ;
- accessibilité et maintenance aisées du ou des creusets ;
- excellente uniformité de l'évaporation et mécanisme simple d'adaptation sur des largeurs de bande pouvant excéder 2 mètres ;
- débit de vapeur maximalisé ;
- régulation aisée du débit de vapeur, par contrôle de la puissance électrique et/ou de la température de surface d'évaporation ;
- conception d'une installation très souple pour des dépôt d'alliage entièrement sous vide.

### Principaux éléments caractéristiques de l'invention

Un premier objet de la présente invention se rapporte à un procédé pour déposer un revêtement d'alliage métallique sur un substrat, de préférence une bande métallique, au moyen d'un générateur de vapeur comprenant une chambre à vide sous forme d'une enceinte, munie de moyens pour y assurer un état de dépression par rapport au milieu extérieur et munie de moyens permettant l'entrée et la sortie du substrat, tout en étant essentiellement étanche par rapport au milieu extérieur, ladite enceinte englobant une tête de dépôt de vapeur, appelée éjecteur, configurée pour créer un jet de vapeur d'alliage métallique à la vitesse sonique en direction de et perpendiculaire à la surface du substrat, ledit éjecteur étant en communication de manière étanche avec un dispositif mélangeur, lui-même relié en amont respectivement à au moins deux creusets et contenant des métaux différents, sous forme liquide, chaque creuset étant relié par une conduite propre au mélangeur, **caractérisé en ce que :**
- on régule la vitesse d'écoulement de chacune des vapeurs métalliques à l'entrée du mélangeur de manière à ce que ladite vitesse d'écoulement desdites vapeurs à l'entrée du mélangeur soit inférieure d'un facteur 10, de préférence d'un facteur 50, à la vitesse sonique;
- on ajuste indépendamment la concentration de chaque métal lors du mélange des vapeurs à déposer sur le substrat.

Avantageusement, le procédé est mis en oeuvre pour que la vitesse d'écoulement soit inférieure à 100 m/s, de préférence 10 à 50 m/s.

Un deuxième aspect de la présente invention se rapporte à un générateur de vapeur pour la mise en oeuvre du procédé précité, comprenant une chambre à vide sous forme d'une enceinte, munie de moyens pour y assurer un état de dépression par rapport au milieu extérieur et munie de moyens permettant l'entrée et la sortie du substrat, tout en étant essentiellement étanche par rapport au milieu extérieur, ladite enceinte englobant une tête de dépôt de vapeur, appelée éjecteur, configurée pour créer un jet de vapeur d'alliage métallique à la vitesse sonique en direction de et perpendiculaire à la surface du substrat, ledit éjecteur étant en communication de manière étanche avec un dispositif mélangeur, lui-même relié en amont respectivement à au moins deux creusets situés à l'extérieur de la chambre à vide et contenant des métaux différents, sous forme liquide, chaque creuset étant relié par une conduite propre au mélangeur, **caractérisé en ce que** le mélangeur comprend une enveloppe cylindrique à l'intérieur de laquelle se trouvent, selon l'axe de l'enveloppe, une pluralité de tubes disposés régulièrement et connectés en entrée à la conduite d'amenée d'une première vapeur métallique, la conduite d'amenée d'une seconde vapeur métallique étant connectée, latéralement par rapport à l'enveloppe cylindrique à l'espace interstitiel entre les tubes. Les tubes et l'espace interstitiel présentent des orifices de sortie débouchant sur un espace où peut se faire le mélange des vapeurs.

Selon des formes d'exécution préférées du générateur de vapeur selon la présente invention, celui-ci comprend en outre une ou plusieurs des caractéristiques suivantes prises en combinaison avec les caractéristiques de base du générateur :
- le mélangeur comprend une série de cloisons permettant de séparer au moins deux vapeurs entrantes, ces cloisons créant des orifices permettant la sortie des deux vapeurs en vue de leur mélange sous forme de couches alternées de l'une et l'autre vapeur dans le sens du flux de sortie ;
- chacune desdites conduites comporte une vanne proportionnelle avec optionnellement un dispositif de perte de charge ;
- la vanne proportionnelle est une vanne de type papillon ;
- l'éjecteur comprend une fente longitudinale de sortie de la vapeur, jouant le rôle de col sonique, s'étendant sur toute la largeur du substrat et un milieu filtrant ou un organe de perte de charge en matière frittée, de préférence réalisé en titane ou sous forme d'un tamis métallique en fibres inox frittées, de sorte à uniformiser et redresser les vecteurs vitesse de la vapeur sortant de l'éjecteur ;
- le générateur comporte des moyens pour ajuster la longueur de la fente à la largeur du substrat ;
- lesdits moyens comprennent des moyens de rotation de l'éjecteur autour de sa conduite d'alimentation ;
- l'éjecteur, le mélangeur, les conduites et les creusets sont isolés thermiquement du milieu extérieur et chauffés par un four à rayonnement ;
- le générateur comporte des moyens de chauffage optionnels de l'enceinte sous vide ;
- une première surface poreuse est disposée à la sortie des tubes et/ou une seconde surface poreuse est disposée à la sortie de l'espace interstitiel, de manière à équilibrer les pressions des deux vapeurs respectives.

Un troisième aspect de la présente invention se rapporte à une installation de dépôt sous vide d'un revêtement d'alliage métallique sur un substrat, de préférence une bande métallique, comprenant un générateur-mélangeur de vapeur selon la revendication 1 permettant de déposer directement sur le substrat, par un jet de vapeur à la vitesse sonique, un premier métal M1 puis un alliage de ce premier métal M1 et d'un second métal M2, une conduite supplémentaire étant montée en dérivation sur la conduite d'amenée du premier métal M1 vers le mélangeur, présentant une vanne d'isolement et aboutissant à un éjecteur supplémentaire dans la chambre à vide, configuré pour créer un jet de vapeur du premier métal M1 à la vitesse sonique en direction de et perpendiculaire à la surface du substrat, la partie de la conduite d'amenée du premier métal M1 aboutissant au mélangeur étant pourvue d'une vanne supplémentaire destinée à isoler le premier creuset du mélangeur.

Encore un autre aspect de la présente invention concerne un procédé de mise en oeuvre de l'installation précitée de dépôt sous vide d'un revêtement d'alliage métallique sur un substrat, de préférence une bande métallique, caractérisé par le fait que, ladite vanne supplémentaire étant fermée et ladite vanne d'isolement étant ouverte, on effectue sur le substrat successivement un dépôt du premier métal M1 au niveau de l'éjecteur supplémentaire et un dépôt du second métal M2 au niveau de l'éjecteur dans la chambre à vide.

Encore un autre aspect de la présente invention concerne un procédé de mise en oeuvre de l'installation précitée de dépôt sous vide d'un revêtement d'alliage métallique sur un substrat, de préférence une bande métallique, caractérisé par le fait que, ladite vanne supplémentaire étant ouverte et ladite vanne d'isolement étant fermée, on effectue sur le substrat un dépôt direct d'alliage M1+M2 au niveau de l'éjecteur dans la chambre à vide.

Encore un autre aspect de la présente invention concerne un procédé de mise en oeuvre de l'installation précitée de dépôt sous vide d'un revêtement d'alliage métallique sur un substrat, de préférence une bande métallique, caractérisé par le fait que, tant ladite vanne supplémentaire que ladite vanne d'isolement étant ouvertes, on effectue sur le substrat successivement un dépôt du premier métal M1 au niveau de l'éjecteur supplémentaire et un dépôt direct d'alliage M1+M2 au niveau de l'éjecteur dans la chambre à vide.

Avantageusement, selon les trois procédés précités, le ou les dépôts de métal ou d'alliage sont suivis d'un traitement thermique.

### Brève description des figures

La figure 1 représente schématiquement un exemple d'exécution du générateur de vapeur industriel déporté comme utilisé selon la présente invention, dans le cas où l'on dépose une seule espèce métallique.

La figure 2 représente schématiquement un générateur de vapeur avec un mélangeur selon l'invention dans une forme d'exécution permettant un dépôt d'alliage de deux métaux purs sur le substrat.

Les figures 3A à 3C représentent des vues de détail du mélangeur de vapeurs métalliques selon une modalité d'exécution préférée de la présente invention.

Les figures 4A et 4B représentent schématiquement respectivement une vue en plan et une vue en élévation d'une installation bimodale complète selon une forme d'exécution préférée de la présente invention, utilisable soit pour le dépôt de deux espèces métalliques distinctes sur une bande métallique, soit pour un dépôt direct d'alliage en utilisant le mélangeur précité.

La figure 5 représente encore des vues en perspective des conduites de l'installation des figures 4A et 4B.

### Description de formes d'exécution préférées de l'invention

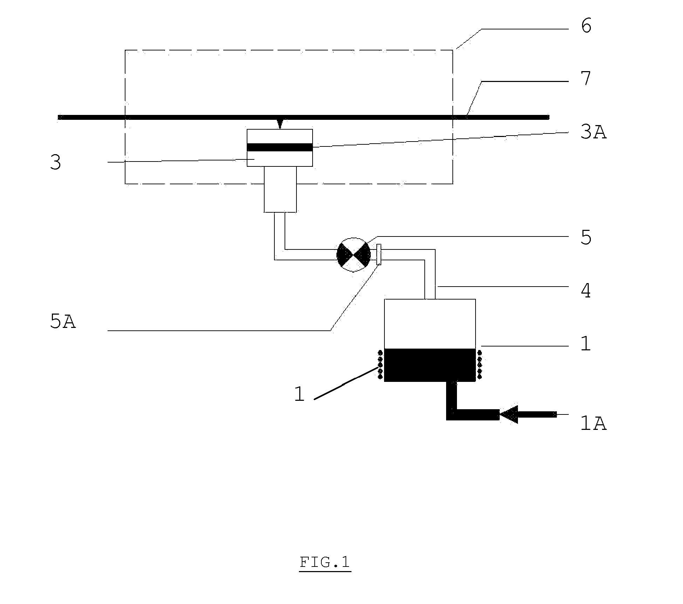

La solution préconisée selon la présente invention consiste à utiliser un creuset d'évaporation déporté, c'est-à-dire qui soit dissocié d'une tête d'évaporation JVD à fente longitudinale ou à trous calibrés pour la sortie de vapeur, appelée ci-après éjecteur. Le principe général d'un tel dispositif à creuset déporté, dans le cas d'une seule espèce de vapeur, est représenté schématiquement sur la figure 1. La présente demande de brevet est cependant axée sur le dépôt d'un revêtement d'alliage et donc nécessite au moins l'utilisation de deux sources différentes de vapeur métalliques. La forme de base du système déporté, qui est protégée par ailleurs, est cependant rappelée ici à des fins de bonne compréhension.

Le creuset 1 est typiquement alimenté par une conduite 1A à partir d'un four de fusion de magnésium par exemple, avec décantation des impuretés. Le type de four de fusion et les conduites utilisés sont des matériels usuellement utilisés dans l'industrie de la fonderie et bien connus de l'homme de métier. Notamment, la fusion et le chargement dans l'appareil selon l'invention se font selon des techniques éprouvées.

Le creuset 1 étant déporté et de forme cylindrique, une bonne uniformité de température peut être atteinte grâce à un brassage magnétique important. Le brassage magnétique assuré par un inducteur 1B monté sur ce creuset permet de conserver une homogénéité dans tout le creuset, les ségrégations d'impuretés non évaporées (décantation et flottaison) se faisant dans le four de fusion (non représenté). On assure ainsi la constance dans le temps des conditions d'évaporation et donc de dépôt. Le brassage magnétique est ajusté par la fréquence d'induction en fonction de la nature du creuset et de sa taille. Une simulation numérique a montré que l'on peut atteindre des vitesses de brassage supérieures à 1 m/s, ce qui permet d'atteindre une parfaite homogénéité.

Le creuset déporté est relié à l'éjecteur 3, qui se trouve dans l'enceinte sous vide 6 dans laquelle passe la bande métallique 7, par une conduite cylindrique 4, dont la section est dimensionnée pour obtenir une vitesse lente (la vitesse à la sortie du creuset est idéalement de l'ordre du mètre par seconde à quelques dizaines de mètre par seconde).

Le choix d'une conduite cylindrique permet d'obtenir une bonne étanchéité au vide à haute température et l'utilisation d'une vanne proportionnelle 5, par exemple une vanne papillon telle que disponible dans le commerce avec éventuellement un dispositif de perte de charge 5A, pour la régulation du débit de vapeur. L'épaisseur déposée dépend du débit de vapeur métallique, le débit étant lui-même proportionnel à la puissance utile fournie. Lorsque la puissance est modifiée, il est possible de changer simultanément la position de la vanne afin d'adapter la perte de charge au nouveau point de fonctionnement. Les débits massiques changent également instantanément, ce qui rend les transitoires quasi inexistants lors du changement de position de la vanne.

L'éjecteur 3 est une boîte de longueur supérieure à la largeur de la bande à revêtir. Ce dispositif contient un milieu filtrant ou créant une perte de charge 3A pour assurer l'uniformisation du débit de vapeur sur toute la longueur de la boîte. L'éjecteur 3 est chauffé à température supérieure à celle de la vapeur métallique et est calorifugé extérieurement. Une fente calibrée ou une série de trous assurent la projection, à la vitesse du son, de la vapeur métallique sur la bande 7. Selon la densité de métal, on obtient des vitesses allant typiquement de 500 à 800 m/s. Le col sonique sur toute la longueur de la fente complète très efficacement le milieu filtrant 3A pour assurer l'uniformité du dépôt sur la bande. La taille de la fente ou des trous S impose le débit volumique (k x Vₛₒₙ x S, k∼0,8). La vitesse du son est atteinte dans l'éjecteur en sortie de la fente ou des trous. Grâce à la présence d'un élément de perte de charge dans la conduite (vanne 5), on peut réguler le débit de vapeur et lui donner une faible pression initiale.

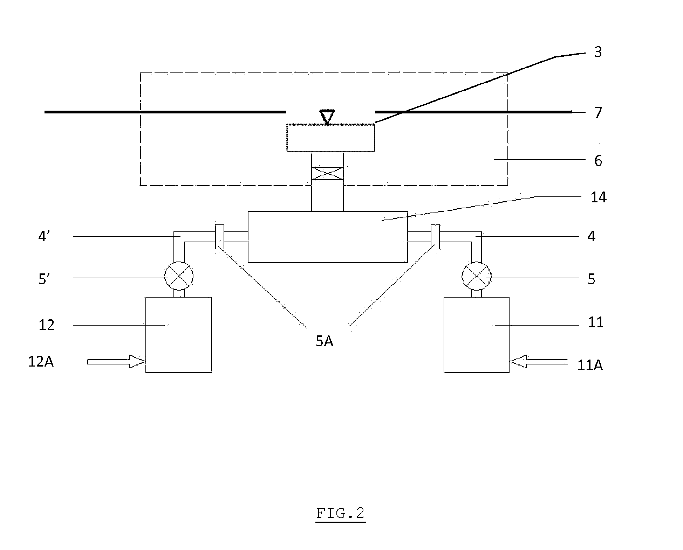

Dans le cas où l'on souhaite mélanger des vapeurs de deux métaux de recouvrement différents, comme représenté sur la figure 2, deux chambres de fusion ou creusets 11, 12 contenant respectivement deux métaux purs différents (par exemple zinc et magnésium) sont reliées chacune par une conduite 4, 4' munie d'une vanne 5, 5' à une chambre de mélange 14 couplée à l'éjecteur 3. La concentration des deux métaux dans le mélange est ajustée d'une part au moyen de l'énergie fournie et d'autre part au moyen des vannes proportionnelles respectives 5, 5', ce qui simplifie le problème de gestion. L'encombrement de ce système est avantageusement réduit (voir ci-dessous).

Ce dispositif permet grâce aux vannes présentes de réguler le débit de vapeur de façon fine et rapide.

Dans l'état de la technique (voir WO 02/06558 A1), les deux conduites d'alimentation de l'éjecteur sont munies de restrictions sous forme d'orifices calibrés. C'est alors à cet endroit que la vitesse du son est obtenue (plusieurs centaines de m/s). S'il faut un temps de mélange t0 pour obtenir un mélange parfait, alors si les vapeurs ont une vitesse v0 à la sortie de ces trous calibrés, l'organe mélangeur devrait avoir une longueur v0 x t0. Par exemple, si v0 = 500 m/s et t0 = 0,2 s, alors v0 x t0 = 100 m ! Il en résulte donc, qu'avec un tel principe, le mélange déposé réellement n'est jamais parfait. Il s'ensuit des problèmes d'homogénéité du revêtement.

Par contre, le dispositif selon l'invention, décrit sur la figure 2, permet de mélanger les vapeurs cette fois à basse vitesse grâce aux éléments de perte de charge incorporés dans le système tels que les vannes. Le mélange se fait entre vapeurs ayant des vitesses d'écoulement régulées et typiquement comprises entre 5 et 50 m/s à l'entrée du mélangeur (ces vitesses d'écoulement étant donc inférieures d'au moins un facteur 10, de préférence d'un facteur 50, à la vitesse sonique), ce qui permet de réduire la longueur d'homogénéité d'un facteur 10 à 100 (typiquement quelques mètres).

De plus, on connaît, dans le cas des mélangeurs, le principe d'accroissement de la diffusion moléculaire si on met en contact alternativement plusieurs couches de deux gaz A et B, plutôt qu'une couche de A et une couche de B. Le nombre de parois de séparation dans le diffuseur permet de diminuer encore sensiblement la longueur de diffusion et le temps de mélange. L'application de ce principe dans un mélangeur du type décrit ci-dessus permet de réduire la longueur de mélange à quelques centimètres, et donc de concevoir un mélangeur de taille réduite, ce qui est un avantage vu la complexité du système (éjecteur sous vide, température élevée).

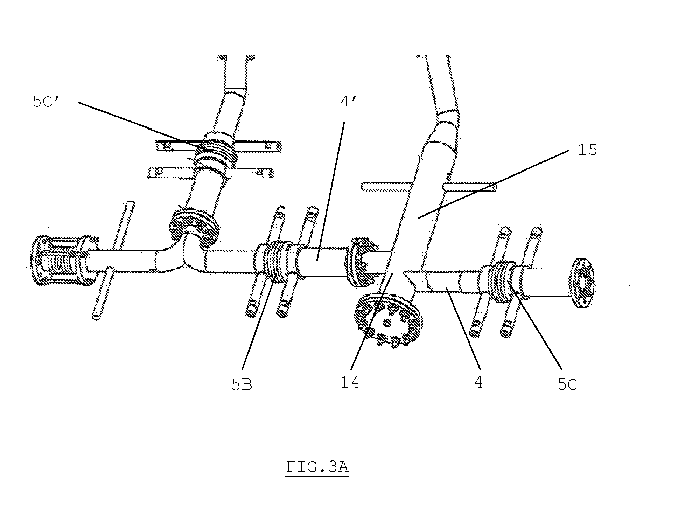

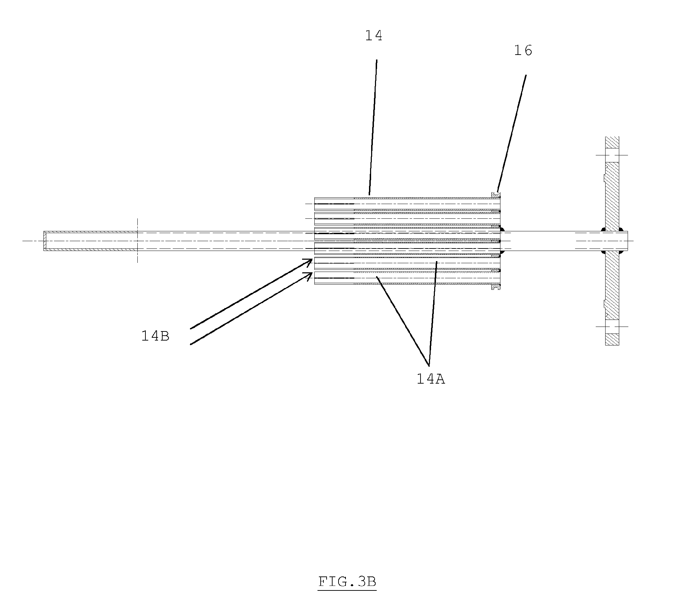

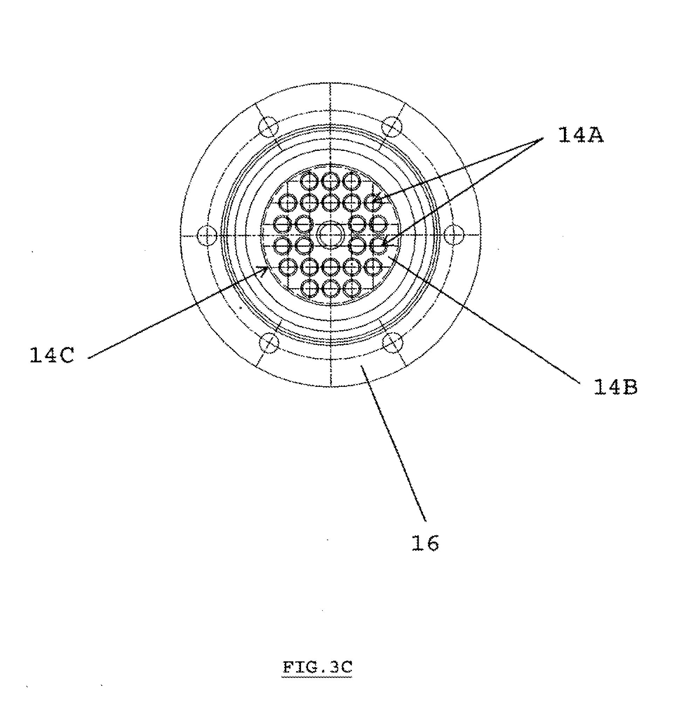

La faisabilité d'un tel mélangeur travaillant avec des vapeurs métalliques à basse vitesse et une distribution alternative a été étudiée par simulation numérique. Le résultat a conduit à la conception d'une forme d'exécution préférée du mélangeur selon l'invention, représentée sur les figures 3A à 3C.

Selon cette forme d'exécution préférée, le dispositif de mélange 14 a la forme d'une enveloppe cylindrique 14C dont l'intérieur comprend une pluralité de tubes 14A disposés régulièrement et connectés à la conduite 4 d'amenée d'une première vapeur métallique M1, selon l'axe du dit cylindre. La conduite 4' d'amenée de la seconde vapeur métallique M2 est connectée, latéralement à l'enveloppe cylindrique, à l'espace interstitiel 14B se trouvant à l'intérieur de ladite enveloppe cylindrique 14C, entre les tubes 14A. Les tubes 14A sont maintenus et fixés sur une bride 16. Tant les tubes 14A que l'espace interstitiel 14B débouchent en sortie sur l'espace de mélange proprement dit 15.

Le choix d'une symétrie cylindrique pour la conception du dispositif de mélange est bien entendu lié à sa bonne tenue en pression.

L'utilisation d'un système déporté à basse vitesse, grâce à des vannes de réglage extérieures, avec un mélangeur de vapeurs présente des avantages certains sur la co-évaporation connue dans l'état de la technique. Il est en effet beaucoup plus facile d'ajuster la teneur en vapeur demandée pour chaque métal grâce à l'action combinée de la puissance et des vannes individuelles respectives sur chaque vapeur. La puissance permet d'ajuster les quantités mélangées et les vannes permettent de fixer et modifier rapidement le point de fonctionnement. On peut en effet, grâce à la perte de charge de la vanne, faire varier la pression sans modifier la température derrière la vanne. A l'inverse, selon l'état de la technique, la modification de pression est toujours subordonnée à la variation de la température, donc du chauffage et génère des inerties et des transitoires.

La pression requise est différente pour les deux métaux M1 et M2 (par ex. T_{évap} (Zn) =600°C et Tₑᵥₐₚ (Mg)= 700°C) car ceux-ci n'ont ni la même densité ni les mêmes caractéristiques physiques.

Dans ces conditions, il est possible d'équilibrer les pressions différentes des deux gaz respectifs en ajoutant au circuit deux éléments de perte de charge additionnels sous forme de surfaces poreuses (non représenté). Une première surface poreuse est disposée à la sortie des tubes 14A (métal M1) et une seconde surface poreuse est disposée à la sortie du gaz interstitiel (métal M2). Dans ce cas, le rééquilibrage des pressions ou des vitesses se fait par frottement, c'est-à-dire par transfert de chaleur et on évite ainsi la détente adiabatique du gaz (sans transfert de chaleur) qui conduirait à la recondensation.

L'avantage de l'invention en la matière est de pouvoir gérer des gaz qui ont des températures ou des pressions différentes à l'entrée, puisque l'on a recours à des pertes de charge sous forme de vannes qui permettent, en combinaison avec la source d'énergie, d'ajuster les teneurs des deux vapeurs métalliques.

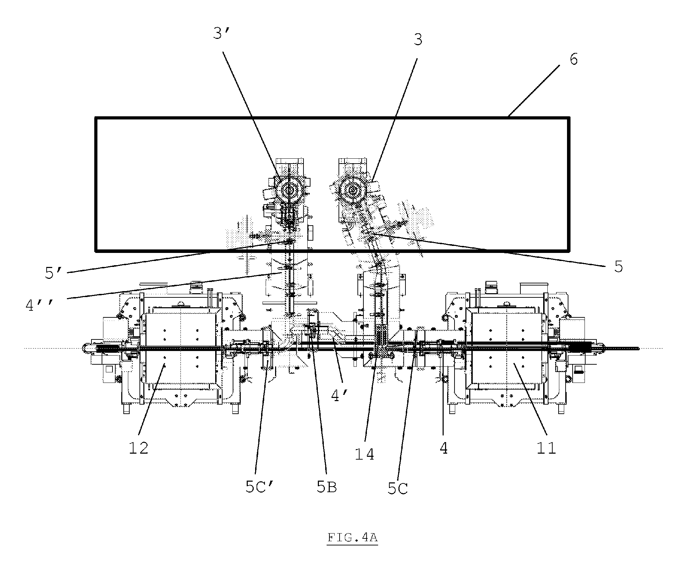

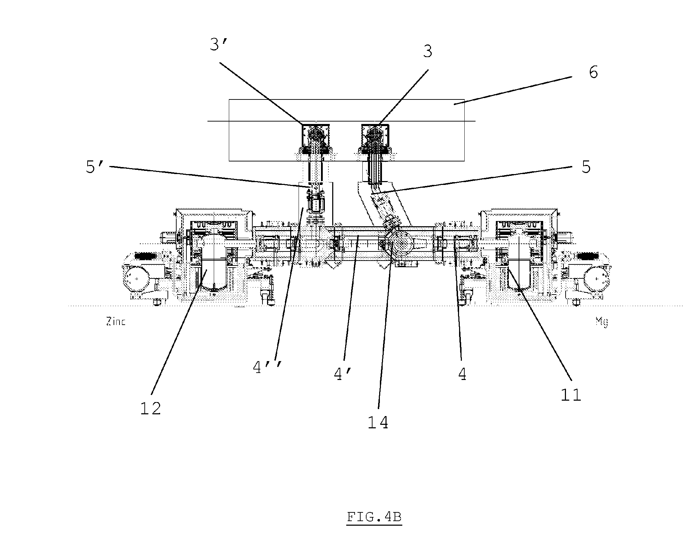

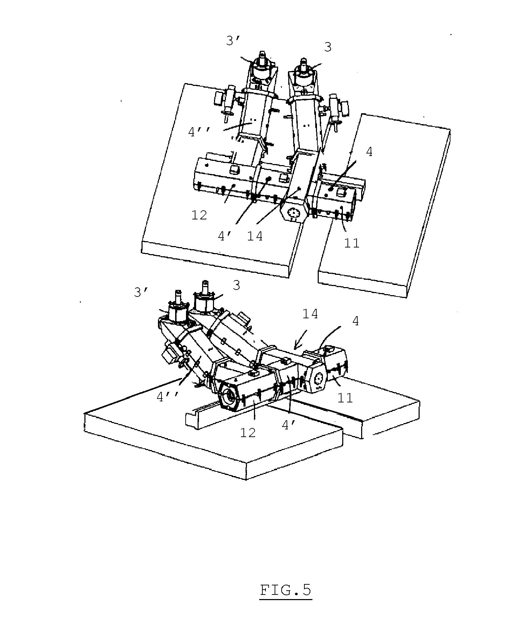

Un autre objet de la présente invention est de proposer une installation de dépôt sous vide « bimodale », représentée sur les figures 4A, 4B et 5, qui permet les modalités de dépôt suivantes :
- dépôt de M1, puis de M2, les deux dépôts étant sous vide,
- dépôt de M1+M2, sous forme d'un mélange effectué comme décrit ci-dessus, le dépôt d'alliage étant sous vide ;
- dépôt de M1+(M1+M2), sous forme d'un mélange effectué comme décrit ci-dessus, le dépôt d'alliage complexe étant sous vide.

Comme on peut le voir sur les figures, la partie de l'installation qui fournit le métal M2 à partir du creuset 11 est munie du mélangeur 14. L'installation peut fonctionner de manière indépendante pour le dépôt de M1 sur la bande métallique au niveau de l'éjecteur 3' dans la chambre sous vide 6, si M1 n'est pas mélangé avec M2, c'est-à-dire si une vanne 5B est fermée dans la partie de la conduite 4' acheminant M1 dans le mélangeur (lorsque cette vanne 5B est ouverte). De même, au cas où cette vanne 5B est fermée, la partie de l'installation fournissant M2 à partir du creuset 11 peut fonctionner de manière autonome et permettre le dépôt de M2 dans la chambre sous vide 6, par exemple au-dessus de la couche déjà déposée de M1 (pour un sens de défilement de la bande de gauche à droite sur la FIG.4A). Par contre, si la vanne 5B précitée est ouverte, le mélange M1+M2 sera effectué dans le mélangeur 14 et déposé sur la bande au niveau de l'éjecteur 3 dans la chambre sous vide 6. D'autres possibilités de dépôt d'alliage sont possibles avec cette installation comme un dépôt de M1 au niveau de l'éjecteur 3' suivi d'un dépôt ultérieur du mélange M1+M2 au niveau de l'éjecteur 3. Il peut en effet être avantageux de réaliser un dépôt d'alliage de zinc et de magnésium sur une sous-couche de zinc, relativement ductile, pour éviter le poudrage du revêtement.

Sur la FIG.4A, les vannes proportionnelles (5, 5') ont été dédoublées par des vannes (5C, 5C') à la sortie des creusets respectifs.

La présente invention s'inscrit dans un contexte d'évolution du domaine technique qui va vers le « full PVD » pour les raisons suivantes :
- dans le dépôt électrolytique, l'augmentation de la vitesse de bande implique l'augmentation des courants nécessaires (millions d'ampères) et donc de la consommation (mégawatts), ce qui est prohibitif du point de vue de la consommation énergétique ; de plus cette technologie génère des éclaboussures, ce qui limite la vitesse de bande maximale à environ 160 mètres/minute ;
- le revêtement au trempé pour le dépôt d'une première couche de zinc se heurte à la limite physique liée à l'essorage dont l'efficacité diminue à haute vitesse ; la limite de vitesse de bande admissible est d'environ 180 mètres/minute ;
- dans le cas du dépôt sous vide, cette limite de 160-180 mètres/minute disparaît car on n'a plus la présence d'une phase liquide pénalisante. Les vapeurs métalliques ont la vitesse du son dans l'enceinte de dépôt et il n'y a donc plus de limite chimique, électrique ou physique. Dans le futur, on peut donc espérer atteindre 200-220, voire 300 mètres/minute, grâce à la technologie de l'invention.

### Avantages de l'invention

Le système selon l'invention permet l'obtention d'une très bonne uniformité de la température et de la vitesse de la vapeur déposée, tout en étant fiable et accessible et en ayant de très faibles temps de réponse. L'invention répond ainsi très bien aux exigences d'industrialisation du procédé.

D'autre part, le dispositif déporté selon l'invention est particulièrement adapté au dépôt d'alliage par mélange de vapeurs car il permet d'ajuster la composition chimique déposée sans avoir à modifier la composition d'un alliage liquide. Le mélange des vapeurs se fait ainsi dans une conduite à très basse vitesse d'écoulement contrairement à l'état de l'art.

Un autre avantage important est de permettre, au moyen du mélangeur du type décrit ci-dessus, l'obtention d'une longueur de mélange allant jusqu'à des valeurs aussi faibles que 300-600 mm, cet avantage étant particulièrement déterminant vu la réduction d'encombrement nécessaire, sachant qu'il convient de maintenir un tel dispositif sous vide à une température d'environ 750°C.

## Revendications

1. Procédé pour déposer un revêtement d'alliage métallique sur un substrat (7), de préférence une bande métallique, au moyen d'un générateur de vapeur comprenant une chambre à vide (6) sous forme d'une enceinte, munie de moyens pour y assurer un état de dépression par rapport au milieu extérieur et munie de moyens permettant l'entrée et la sortie du substrat (7), tout en étant essentiellement étanche par rapport au milieu extérieur, ladite enceinte englobant une tête de dépôt de vapeur, appelée éjecteur (3), configurée pour créer un jet de vapeur d'alliage métallique à la vitesse sonique en direction de et perpendiculaire à la surface du substrat (7), ledit éjecteur (3) étant en communication de manière étanche avec un dispositif mélangeur (14), lui-même relié en amont respectivement à au moins deux creusets (11, 12) et contenant des métaux différents, sous forme liquide, chaque creuset (11, 12) étant relié par une conduite propre (4, 4') au mélangeur (14), **caractérisé en ce que :**
- on régule la vitesse d'écoulement de chacune des vapeurs métalliques à l'entrée du mélangeur (14) de manière à ce que ladite vitesse d'écoulement desdites vapeurs à l'entrée du mélangeur soit inférieure d'un facteur 10, de préférence d'un facteur 50, à la vitesse sonique ;
- on ajuste indépendamment la concentration de chaque métal lors du mélange des vapeurs à déposer sur le substrat (7).

2. Procédé selon la revendication 1, **caractérisé en ce que** la vitesse d'écoulement est inférieure à 100 m/s, de préférence 10 à 50 m/s.

3. Générateur de vapeur pour la mise en oeuvre du procédé selon la revendication 1, comprenant une chambre à vide (6) sous forme d'une enceinte, munie de moyens pour y assurer un état de dépression par rapport au milieu extérieur et munie de moyens permettant l'entrée et la sortie du substrat (7), tout en étant essentiellement étanche par rapport au milieu extérieur, ladite enceinte englobant une tête de dépôt de vapeur, appelée éjecteur (3), configurée pour créer un jet de vapeur d'alliage métallique à la vitesse sonique en direction de et perpendiculaire à la surface du substrat (7), ledit éjecteur (3) étant en communication de manière étanche avec un dispositif mélangeur (14), lui-même relié en amont respectivement à au moins deux creusets (11, 12) situés à l'extérieur de la chambre à vide (6) et contenant des métaux différents, sous forme liquide, chaque creuset (11, 12) étant relié par une conduite propre (4, 4') au mélangeur (14), **caractérisé en ce que** le mélangeur (14) comprend une enveloppe cylindrique (14C) à l'intérieur de laquelle se trouvent, selon l'axe de l'enveloppe, une pluralité de tubes (14A) disposés régulièrement et connectés en entrée à la conduite d'amenée (4) d'une première vapeur métallique, la conduite d'amenée (4') d'une seconde vapeur métallique étant connectée, latéralement par rapport à l'enveloppe cylindrique à l'espace interstitiel (14B) entre les tubes (14A), les tubes (14A) et l'espace interstitiel (14B) présentant des orifices de sortie débouchant sur un espace (15) où peut se faire le mélange des vapeurs.

4. Générateur selon la revendication 3,
**caractérisé en ce que** le mélangeur (14) comprend une série de cloisons permettant de séparer au moins deux vapeurs entrantes, ces cloisons créant des orifices permettant la sortie des deux vapeurs en vue de leur mélange sous forme de couches alternées de l'une et l'autre vapeur dans le sens du flux de sortie.

5. Générateur selon la revendication 3,
**caractérisé en ce que** chacune desdites conduites (4, 4') comporte une vanne proportionnelle (5, 5') avec optionnellement un dispositif de perte de charge (5A).

6. Générateur selon la revendication 5,
**caractérisé en ce que** la vanne proportionnelle (5, 5') est une vanne de type papillon.

7. Générateur selon la revendication 3,
**caractérisé en ce que** l'éjecteur (3) comprend une fente longitudinale de sortie de la vapeur, jouant le rôle de col sonique, s'étendant sur toute la largeur du substrat et un milieu filtrant ou un organe de perte de charge (3A) en matière frittée, de préférence réalisé en titane ou sous forme d'un tamis métallique en fibres inox frittées, de sorte à uniformiser et redresser les vecteurs vitesse de la vapeur sortant de l'éjecteur (3).

8. Générateur selon la revendication 7,
**caractérisé en ce qu'**il comporte des moyens pour ajuster la longueur de la fente à la largeur du substrat.

9. Générateur selon la revendication 8,
**caractérisé en ce que** lesdits moyens comprennent des moyens de rotation de l'éjecteur (3) autour de sa conduite d'alimentation (4).

10. Générateur selon la revendication 3,
**caractérisé en ce que** l'éjecteur (3), le mélangeur (14), les conduites (4, 4') et les creusets (11, 12) sont isolés thermiquement du milieu extérieur et chauffés par un four à rayonnement.

11. Générateur selon la revendication 3,
**caractérisé en ce qu'**il comporte des moyens de chauffage optionnels de l'enceinte sous vide (6).

12. Générateur selon la revendication 3,
**caractérisé en ce qu'**une première surface poreuse est disposée à la sortie des tubes (14A) et/ou une seconde surface poreuse est disposée à la sortie de l'espace interstitiel (14B), de manière à équilibrer les pressions des deux vapeurs respectives.

13. Installation de dépôt sous vide d'un revêtement d'alliage métallique sur un substrat (7), de préférence une bande métallique, comprenant un générateur-mélangeur de vapeur selon la revendication 3 permettant de déposer directement sur le substrat (7), par un jet de vapeur à la vitesse sonique, un alliage d'un premier métal M1 et d'un second métal M2, une conduite supplémentaire (4') étant montée en dérivation sur la conduite (4') d'amenée du premier métal M1 vers le mélangeur (14), présentant une vanne d'isolement (5') et aboutissant à un éjecteur supplémentaire (3') dans la chambre à vide (6), configuré pour créer un jet de vapeur du premier métal M1 à la vitesse sonique en direction de et perpendiculaire à la surface du substrat (7), la partie de la conduite d'amenée (4') du premier métal M1 aboutissant au mélangeur (14) étant pourvue d'une vanne (5B) supplémentaire destinée à isoler le premier creuset (12) du mélangeur (14).

14. Procédé de mise en oeuvre de l'installation de dépôt sous vide d'un revêtement d'alliage métallique sur un substrat (7), de préférence une bande métallique, selon la revendication 13, **caractérisé par le fait que**, ladite vanne supplémentaire (5B) étant fermée et ladite vanne d'isolement (5') étant ouverte, on effectue sur le substrat (7) successivement un dépôt du premier métal M1 au niveau de l'éjecteur supplémentaire (3') et un dépôt du second métal M2 au niveau de l'éjecteur (3) dans la chambre à vide (6).

15. Procédé de mise en oeuvre de l'installation de dépôt sous vide d'un revêtement d'alliage métallique sur un substrat (7), de préférence une bande métallique, selon la revendication 13, **caractérisé par le fait que**, ladite vanne supplémentaire (5B) étant ouverte et ladite vanne d'isolement (5') étant fermée, on effectue sur le substrat (7) un dépôt direct d'alliage M1+M2 au niveau de l'éjecteur (3) dans la chambre à vide (6).

16. Procédé de mise en oeuvre de l'installation de dépôt sous vide d'un revêtement d'alliage métallique sur un substrat (7), de préférence une bande métallique, selon la revendication 13, **caractérisé par le fait que**, tant ladite vanne supplémentaire (5B) que ladite vanne d'isolement (5') étant ouvertes, on effectue sur le substrat (7) successivement un dépôt du premier métal M1 au niveau de l'éjecteur supplémentaire (3') et un dépôt direct d'alliage M1+M2 au niveau de l'éjecteur (3) dans la chambre à vide (6).

17. Procédé selon la revendication 14, 15 ou 16, **caractérisé en ce que** le ou les dépôts de métal ou d'alliage sont suivis par un traitement thermique.
